# EUROPEAN PATENT SPECIFICATION

(11) **EP 2 855 314 B1**
(45) Date of publication and mention of the grant of the patent: **31.08.2016**
(21) Application number: 13724298.8
(22) Date of filing: 24.05.2013
(51) Int. Cl.: H05K 7/20, B65H 18/28

(54) **METHOD FOR FORMING AN IMAGE**
VERFAHREN ZUR ERZEUGUNG EINES BILDES
PROCÉDÉ DE FORMATION D'UNE IMAGE

(30) Priority: 31.05.2012 EP 12170130
(43) Date of publication of application: 08.04.2015
(73) Proprietor: OCE-Technologies B.V., 5914 CA Venlo (NL)
(72) Inventor: SEVENICH, Johannes B.M., NL-6041 XL Roermond (NL)
(86) International application number: PCT/EP2013/060734
(87) International publication number: WO 2013/178547

(56) References cited:
- EP-A1- 2 174 787
- US-A1- 2005 063 023
- US-A1- 2010 059 929
- US-A1- 2010 148 425

## Description

### Field of the Invention

The present invention relates to a method for conditioning a recording medium storage enclosure in a printing system. The present invention further relates to a printing system comprising a printing station and a recording medium storage enclosure. The present invention further relates to an air flow kit for conditioning a recording medium storage enclosure.

### Background of the Invention

In a known method for conditioning a recording medium enclosure in a printing system a recording medium is provided in the form of a roll of an endless web wound on the reel inside a recording medium enclosure. The printing system further has a feeding path leading from the reel to a printing station for feeding a portion of the recording medium, a cutting device disposed at the feed path for cutting the web, and a feed control system.

In printers in which paper sheets or similar image receiving sheets are used as recording media, a tendency of the paper to cockle may occur. The cockling phenomenon is related to the fact that paper and similar materials tend to absorb humidity from ambient air and to expand and contract in accordance with their humidity content. When there exists a gradient in humidity within the paper, or any other non homogeneous state of humidity in the paper, then the more humid portion of the paper will expand more than the drier portion, which leads to the production of cockles or wrinkles.

In case the printing system terminates a print operation, a leading edge of the web, which has been cut after printing, is located in the feed path. Then, an end portion of the web that is present in the feed path inside the recording medium enclosure will be exposed to ambient air from both sides and can therefore absorb a large amount of moisture.

In order to reduce a moisture absorption by the end portion of the web the feed control system of the printing system is adapted to withdraw that end portion of the web onto the peripheral surface of the roll when the printing system is in a non-printing condition. When the print operation is continued, the web has to be feed again into the feed path, which needs a separating step for separating the leading edge from the surface of the roll, leading to a loss of productivity during resumption of the print operation. A gradient in humidity within the paper will still grow in time as the outer layer of the roll is exposed to ambient air, which will eventually lead to a higher humidity content of the leading end portion of the web.

In US2010/059929 a sheet feeding device is disclosed that accomodates a sheet stack of a plurality of sheets. The sheet feeding device includes a lateral warm air mechanism for blowing heated air towards the side face of the sheet stack in a sheet feeding position.

### Summary of the Invention

In an aspect of the present invention, a method for conditioning a recording medium storage enclosure in a printing system is provided, which is capable of reducing effects of ambient air conditions on humidity conditions of a recording medium in a recording medium storage enclosure.

In a first aspect of the present invention a method for conditioning a recording medium storage enclosure in a printing system is provided, the recording medium storage enclosure comprising an exit opening being arranged at a first end of the recording medium storage enclosure, which exit opening is configured for releasing a portion of a recording medium towards a printing station of the printing system, the method comprising the steps of:
a) providing an air flow inside the recording medium storage enclosure in a main air flow direction adjacent to the exit opening, wherein the main air flow direction is aligned along a direction of the exit opening, which is substantially perpendicular to a feeding direction of a recording medium through the exit opening;
b) circulating a first portion of the air flow provided in step a) within the recording medium storage enclosure between the first end and a second end of the recording medium storage enclosure opposite of the first end; and
c) directing a second portion of the air flow provided in step a) towards the exit opening in order to provide an overpressure inside the recording medium storage enclosure adjacent to the exit opening with respect to an ambient pressure outside the recording medium storage enclosure.

The recording medium storage enclosure is configured for storing a recording medium. The recording medium storage enclosure comprises an exit opening, which is arranged at a first end of the recording medium storage enclosure. A shape of the exit opening is suitably selected for guiding a portion of the recording medium from inside the recording medium storage enclosure outward. The recording medium storage enclosure may be

substantially closed, and may be partially closed. Preferably the recording medium storage enclosure is for the most part closed. Openings in the recording medium storage enclosure are possible in so far as these openings do not prohibit the circulation of a portion of the air flow in the recording medium storage enclosure.

In the air flow step a) an air flow is provided inside the recording medium storage enclosure in a main air flow direction adjacent to the exit opening. The main air flow direction is the predominant flow direction of the air flow. The air flow is provided in the main air flow direction adjacent to the exit opening in order to minimize a flow of ambient air through the exit opening. Attributes of the air flow, such as a flow rate and a distance between the main air flow direction and the exit opening, may be suitably selected. The main air flow direction is aligned along a direction of the exit opening, which is substantially perpendicular to a feeding direction of a recording medium through the exit opening. As a result an air flow through the exit opening is minimized.
It has been found that the feeding direction of the recording medium is usually a most sensitive direction towards an air flow through the exit opening. In case a different direction of the exit opening is more sensitive, the main air flow may suitably be adapted, such that it is perpendicular to the more sensitive direction of the exit opening. In a circulating step b) a first portion of the air flow, which is provided in the main air flow direction, is circulated between the first end and the second end of the recording medium storage enclosure opposite of the first end. Circulating the first portion of the air flow means that the first portion is moved from the first end to the second end of the recording medium storage enclosure, and sub sequently is moved back from the second end to the first end of the recording medium storage enclosure. Means may be provided in the recording medium storage enclosure for supporting the circulation of the first portion of the air flow between the first end and the second end (e.g. air flow ducts, air flow distribution means, etc).
The first portion of the air flow enhances that a micro climate inside the recording medium storage enclosure is made uniform. The micro climate is a local atmospheric zone within the recording medium storage enclosure where the climate differs from the surrounding area of the recording medium storage enclosure. For example in case the humidity of the air at the first end of the recording medium storage enclosure is higher than the humidity of the air at the second end of the recording medium storage enclosure, the circulating first portion of the air flow reduces the difference in humidity of the air of the first end and the second end of the recording medium storage enclosure. In an exit directing step c) a second portion of the air flow, which is provided in the main air direction, is directed towards the exit opening in order to provide an overpressure inside the recording medium storage enclosure adjacent to the exit opening with respect to an ambient pressure outside the recording medium storage enclosure. The second portion of the air flow further prohibits ambient air from entering the recording medium storage enclosure through the exit opening. The second portion of the air flow may affect the remaining air pressure inside recording medium enclosure away from the exit opening. The second portion of the air flow is suitably selected such that the air pressure inside recording medium enclosure away from the exit opening is decreased little, in order that not too much air is sucked in the recording medium storage enclosure at a position away from the exit opening.
As a result the air conditions inside the enclosure are equalized (i.e. an uniform microclimate is provided) while at the same time ambient air conditions are kept outside of the enclosure. As a result of the uniform microclimate inside the recording medium storage enclosure a gradient in humidity within the paper may also be reduced by the present method leading to a reduction of cockling of the paper.

In an embodiment of the method, step a) further comprises aligning the main air flow direction along a feed path of the recording medium, which feed path is configured for conveying the recording medium towards the exit opening. A leading edge of the recording medium may be retained, after termination of the print operation, in the feed path close to the exit opening. By aligning the main air flow direction of step a) along the feed path of the recording medium, the air in the feed path is circulated within the recording medium storage enclosure during step b). Furthermore, in case a leading edge of the recording medium is present in the feed path, the conditioning of the leading end portion of the recording medium is optimized and the leading end portion is protected from ambient air conditions. A feed path may comprise several guiding plates for conveying the recording medium towards the exit opening. The main air flow direction may be aligned with a surface of one of the guiding plates.

In an embodiment of the method, the first portion of the air flow of step b) is larger than the second portion of the air flow of step c). The circulating first portion provides an uniform microclimate and the exit directed second portion provides an overpressure adjacent to the exit opening with respect to an ambient pressure outside the recording medium storage enclosure. The first portion being larger than the second portion provides that an uniform microclimate can be attained faster. The exit opening may be suitably configured, such that a second portion of the air flow is sufficient to prohibit ambient air from entering the recording medium storage enclosure through the exit opening.

In an embodiment of the method, the air of the air flow provided in step a) is pre-heated above ambient air temperature prior to step a). Pre-heated air inside the recording medium storage enclosure provides that an overall air pressure inside the recording medium storage enclosure adjacent to the exit opening increases, thereby even further prohibiting ambient air from entering the recording medium storage enclosure through the exit opening. Further more the pre-heated air reduces a humidity of a recording medium during circulation step b). In case a leading edge has been exposed to humid ambient air outside of the recording medium storage enclosure, a resulting gradient in humidity within the recording medium is reduced faster during conditioning inside the recording medium storage enclosure.

In an embodiment of the method, the air of the air flow provided in step a) is dehumidified with respect to an ambient air humidity prior to step a). The dehumidified air reduces a humidity of a recording medium during circulation step b). In case a leading edge has been exposed to humid ambient air outside of the recording medium storage enclosure, a resulting gradient in humidity within the recording medium is reduced faster during conditioning inside the recording medium storage enclosure.

In an embodiment of the method, the method further comprises step d) feeding a portion of the recording medium through the exit opening of the recording medium storage enclosure towards the print station of the printing system, and wherein step a) is performed after step d) has ended. A tendency of the recording medium to cockle is further reduced, in case the air flow is provided during a retraction movement of the leading edge into the recording medium storage enclosure and in case the air flow is provided during a first period directly after a termination of the print operation.

In another aspect of the present invention a printing system is provided, which comprises a printing station and a recording medium storage enclosure, wherein the recording medium storage enclosure comprises:
a) an exit opening arranged at a first end of the recording medium storage enclosure for releasing a portion of a recording medium towards the printing station of the printing system;
b) an air flow source for providing a circulating air flow inside the recording medium storage enclosure between the first end and the second end of the recording medium storage enclosure opposite of the first end;
c) an air flow manifold for directing the air flow at the first end of the recording medium storage enclosure in a main air flow direction adjacent to the exit opening, wherein the main air flow direction is aligned along a direction of the exit opening, which is substantially perpendicular to a feeding direction of a recording medium through the exit opening; and
d) a distribution means arranged at the first end for directing a circulating first portion of the air flow from the first end to the second end of the recording medium storage enclosure and directing a second portion of the air flow towards the exit opening in order to provide an overpressure inside the recording medium storage enclosure adjacent to the exit opening with respect to an ambient pressure outside the recording medium storage enclosure,
the printing system further comprises a control unit for controlling the air flow source. The air flow source may be an air pump, or any other means to provide an air flow. The air flow manifold is arranged at the first end of the recording medium storage enclosure in order to direct the air flow in the main air flow direction adjacent to the exit opening. The air flow manifold may suitably be configured to adjust attributes of the air flow, such as a flow rate and a distance between the main air flow direction and the exit opening. In an embodiment the air flow manifold may be configured to provide an air curtain along a direction of the exit opening. An air curtain is an air flow in the main air flow direction, which covers a substantially complete area of the exit opening perpendicular to a feeding direction of a recording medium through the exit opening (e.g. covers a height of the exit opening).

In an embodiment of the printing system, the air flow manifold is arranged for aligning the main air flow direction along a feed path configured for conveying the recording medium towards the exit opening. By aligning the main air flow direction of step a) along the feed path of the recording medium, the air in the feed path is circulated within the recording medium storage enclosure during step b).

In an embodiment of the printing system, the printing system further comprises a sensor for sensing an ambient air condition and wherein the control unit controls the air flow source based on a sensor signal provided by the sensor to the control unit indicating the ambient air condition. This improves the conditioning of the recording medium storage enclosure. For example a flow rate of the air flow may be adapted based on one or more of the conditions of an ambient air pressure and a humidity of the ambient air.

In an embodiment of the printing system, the recording medium storage enclosure further comprises a duct arranged for channeling the air flow from the second end of the recording medium storage enclosure towards the air flow manifold. This supports the circulating step b). The duct may be connected to the air flow manifold and may be connected to the air flow source. The duct may be a channel, may be a tube, may be a hollow cylinder and may be any other means for channeling the air flow from the second end of the recording medium storage enclosure towards the air flow manifold.

In an embodiment of the printing system, the recording medium storage enclosure further comprises a recording medium supporting means for supporting the recording medium, being arranged between the first end and the second end of the recording medium storage enclosure. The recording medium supporting means may be suitably arranged inside the recording medium storage enclosure in order to support the circulating step b).

In an embodiment of the printing system, recording medium storage enclosure further comprises a feed control system for in operation feeding a portion of the recording medium in the recording medium storage enclosure towards the printing station of the printing system, and wherein the control unit controls the air flow source based on the feeding operation by the feed control system. A reduction of the recording medium to cockle is further optimised, in case the air flow is provided based on the feeding operation by the feed control system. For example during a retraction movement of the leading edge into the recording medium storage enclosure and in case the air flow is provided during a first period directly after a termination of the feeding operation.

In another aspect of the present invention an air flow kit is provided for conditioning a recording medium storage enclosure, the recording medium storage enclosure comprising an exit opening for releasing a portion of a recording medium towards the printing station of the printing system, wherein the air flow kit comprises:
a) an air flow source for providing a circulating air flow inside the recording medium storage enclosure between a first end of the recording medium storage enclosure adjacent to the exit opening and a second end of the recording medium storage enclosure opposite of the first end;
b) an air flow manifold for directing the air flow at the first end of the recording medium storage enclosure in a main air flow direction adjacent to the exit opening;
c) a distribution means for directing a circulating first portion of the air flow from the first end to the second end of the recording medium storage enclosure and directing a second portion of the air flow towards the exit opening in order to provide an overpressure inside the recording medium storage enclosure adjacent to the exit opening with respect to an ambient pressure outside the recording medium storage enclosure; and
d) a duct for channeling the air flow from the second end of the recording medium storage enclosure towards the air flow manifold.
The air flow kit may be suitably arranged inside a recording medium storage enclosure in order to provide a method for conditioning the recording medium storage enclosure according to the present invention. The air flow source is arranged in the circulating air flow path between the first end and the second end of the recording medium storage enclosure.
The air flow manifold is arranged close to the exit opening, wherein the arrangement is suitable to direct the air flow in a main air flow direction adjacent to the exit opening. The distribution means is arranged along the main air flow direction close to the exit opening. The distribution means may be arranged at any position with respect to the exit opening along the main air flow path; for example preceding the exit opening, next to the exit opening or subsequently to the exit opening in the main air flow direction. The distribution means may be connected to the air flow manifold.
The duct is arranged between the second end and the air flow manifold at the first end of the recording medium storage enclosure. The duct may be connected to the air flow manifold and may be connected to the air flow source.

Further scope of applicability of the present invention will become apparent from the detailed description given hereinafter. However, it should be understood that the detailed description and specific examples, while indicating embodiments of the invention, are given by way of illustration only, since various changes and modifications within the scope of the invention will become apparent to those skilled in the art from this detailed description.

### BRIEF DESCRIPTION OF THE DRAWINGS

Hereinafter, the present invention is further elucidated with reference to the appended drawings showing non-limiting embodiments and wherein
- Fig. 1A: shows a schematic vertical cross-section of a paper transport system of an ink jet printer; and
- Figs. 1B: is an enlarged schematic view of a prior art recording medium storage enclosure.
- Fig. 2A: shows a schematical plan view of a recording medium storage enclosure according to a first embodiment of the present invention.
- Fig. 2B: shows a schematical cross section view of the recording medium storage enclosure along the line D-D of the embodiment of Fig. 2A.
- Fig. 2C: shows an enlarged view of the distribution means of the first embodiment shown in Fig. 2A.
- Fig. 3: shows a schematical plan view of a recording medium storage enclosure according to a second embodiment of the present invention.
- Fig. 4A: shows a schematical plan view of a recording medium storage enclosure according to a third embodiment of the present invention.
- Fig. 4B: shows a schematical cross section view of the recording medium storage enclosure along the line D-D of the embodiment of Fig. 4A.
- Fig. 5A: shows a schematical side view of a recording medium storage enclosure according to a fourth embodiment of the present invention.
- Fig. 5B: shows a schematical plan view of the recording medium storage enclosure along the line D-D of the embodiment of Fig. 5A.
- Fig. 6: shows a flow-chart of a method according to the present invention.

### DETAILED DESCRIPTION OF EMBODIMENTS

The present invention will now be described with reference to the accompanying drawings, wherein the same reference numerals have been used to identify the same or similar elements throughout the several views.

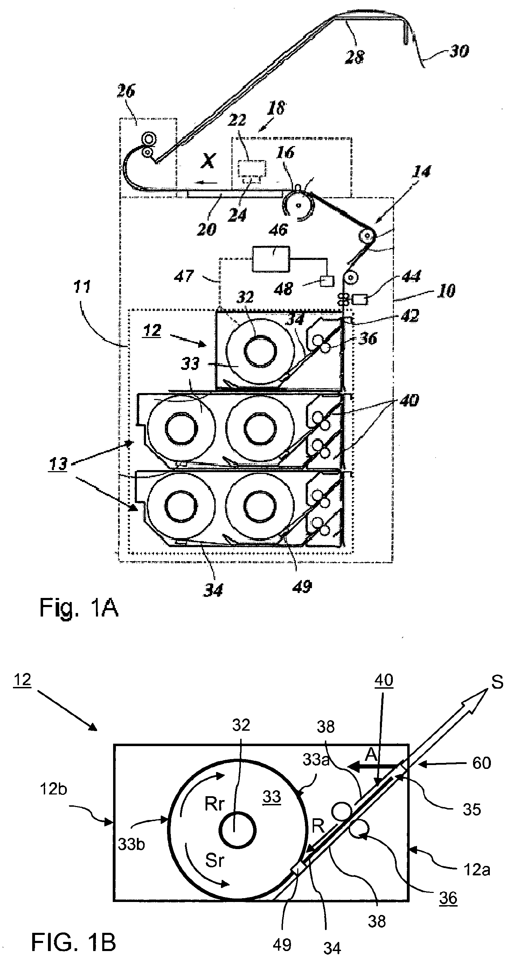

As is shown in Fig. 1A, an ink jet printer comprises a frame 10 (which has only been shown in phantom lines) and which accommodates a paper storage unit 11 and a paper feed system 14 adapted to feed a sheet 16 of paper to a printing station 18 on the top side of the frame 10. In the printing station 18, the sheet 16 is moved over a sheet support plate 20. A carriage 22 is arranged to travel back and forth across the sheet 16 in the direction normal to the plane of the drawing in Fig. 1A and carries at its bottom side a number of ink jet print heads 24 facing the sheet 16. Thus, by energising the print heads 24, a swath of an image is printed in each pass of the carriage 22. Then, the sheet 16 is advanced by a step of appropriate length in a direction indicated by an arrow X, so that the next swath can be printed. A discharge mechanism 26 discharges the sheet onto a tray 28 which, in the example shown, accommodates already a printed sheet 30.
The paper storage unit 11 comprises one recording medium storage enclosure 12, accommodating a reel 32 and two larger recording medium storage enclosures 13 for accommodating two reels 32, each reel providing a supply of printing paper in the form of a paper roll 33. In each recording medium storage enclosure a web 34 is drawn-off from each paper roll 33 by means of an associated pair of transport rollers 36. Each of the recording medium storage enclosures 12, 13 comprises narrow feed paths 40, which merge into a common transport path 42 on the top side of the paper storage unit 11. The pairs of transport rollers 36 are selectively driven to feed the web 34 from a selected one of the reels 32 in one of the recording medium storage enclosures 12,13 to the common transport path 42. It will be understood that the reels 32 may contain paper of different qualities and possibly also non-paper recording media such as plastic films or the like. Further, the webs on the reels 32 may differ in width, so that printed sheets may be produced in different formats, ranging for example from A4 portrait to A0 landscape. With the phrase "endless web 34" it is meant that the length of paper on reels 32 is long compared to the cutted sizes A4 or A0. Typically the length of such a web is between 20 and 200 meters but can be also longer than that.
From the common transport path 42, the selected web is guided past a cutting mechanism 44 for cutting the web to the desired sheet length.
On its way from the reel 32 to the sheet support plate 20, the web 34 and the sheet 16, respectively, will be exposed to ambient air and, as a result, will absorb humidity, especially when the relative humidity RH of the ambient air is high.
When the humidity content of the paper increases, it tends to expand. Typically, the paper expands in the direction transverse to the longitudinal direction of the web. When the sheet 16, after having expanded in this way, reaches the sheet support plate 20, part of the water contained in the paper will be evaporated, and the paper shrinks again in width direction of the sheet. Thus, since a humidity gradient is present in the paper, the accompanying expansion in width of the sheet leads to the production of cockles.

Figs. 1 B is an enlarged schematic view of a prior art recording medium storage enclosure shown in figure 1A. In Figs. 1 B the recording medium storage enclosure 12 is shown, which accommodates a reel 32 for providing a supply of printing paper in the form of an endless web 34. Recording medium storage enclosure 12 comprises an exit opening 60 at a first end 12a of the recording medium storage enclosure for releasing a portion of a recording medium towards the printing station of the printing system. An arrangement of guide plates 38 defines the feed path 40. In Figs. 1 B it is shown that the recording medium storage enclosure 12 is capable of withdrawing a web 34, that has been fed into the feed path 40, back onto the roll 33 on the reel 32 from which it had been drawn-off. Each of the reels 32 is independently driven by an electric motor, which has not been illustrated, and may rotate in either direction under the control of an electronic feed control system 46 (Figure 1A), as has been symbolized by dashed lines 47 for the upper reel 32 in figure 1A.
The feed control system 46 is also connected to a humidity sensor 48. Further, the feed control system 46 is connected to a separating mechanism 49 (Fig. 1 B) that is arranged at the periphery of each of the reels 32 at a position where the web 34 is drawn off from the roll 33.
Figs. 1 B illustrates a condition where a web 34, which has been drawn off from a paper roll 33 on the reel 32, has just been cut by means of the cutting device 44, so that the leading edge 35 of the web is located in the paper feed path 40 near the exit opening 60 of the recording medium storage enclosure. When, at that instant, a new print job has already been programmed, and this print job specifies that the recording medium shall be the same web 34 that is already in the feed path, then the web 34 will be fed further towards the print station 18 as indicated by arrow S.
On the other hand, if no new print job is in the print queue, the leading edge 35 of the web may be retained in the paper feed path 40 near the exit opening 60 of the recording medium storage enclosure. However ambient air is able to enter the recording medium storage enclosure 12 through the exit opening 60 as is indicated by arrow A. As a result a gradient of humidity may develop in the recording medium storage enclosure between a first end 12a of the recording medium storage enclosure, where the exit opening 60 is arranged, and a second end 12b of the recording medium storage enclosure. This causes the leading edge 35 of the web, being arranged in the paper feed path 40, to be exposed to a relatively high humidity and a peripheral surface of the roll 33b to be exposed to a relatively low humidity.

Alternatively, in case the feed control system 46 reads the air humidity that has been detected by the sensor 48, and if the air humidity is above a certain threshold level, the reel 32 is driven in reverse direction, as is indicated by an arrow Rr in Figs. 1 B, so as to withdraw the web 34 from the paper feed path 40, as indicated by arrow R in Figs. 1 B, and back onto the periphery of the roll 33. The rotation of the reel 32 will be stopped when it is detected that the leading edge 35 of the web has reached the position of the separating device 49. Thus, the entire length of the web 34 is stored in a compacted state in the roll 33.
Also when the entire length of the web 34 is stored in a compacted state in the roll 33, a gradient of humidity inside the recording medium storage enclosure may grow, which causes a portion 33a of the peripheral surface of the roll, being arranged near the first end 12a of the recording medium storage enclosure, to be exposed to a relatively high humidity and a portion 33b of the peripheral surface of the roll to be exposed to a relatively low humidity.
Furthermore when a new print job is entered, the printer is again switched into the printing operating mode, and the feed control system 46 controls the reel 32 to rotate in feed direction, as has been indicated by an arrow Sr. Simultaneously, the separating mechanism 49 is activated so as to separate the leading edge of the web from the periphery of the roll 33, e.g. by air suction. The separation of the leading edge from the periphery of the roll 33 requires time and the feeding of the leading edge towards the exit opening 60 of the recording medium storage enclosure is delayed.

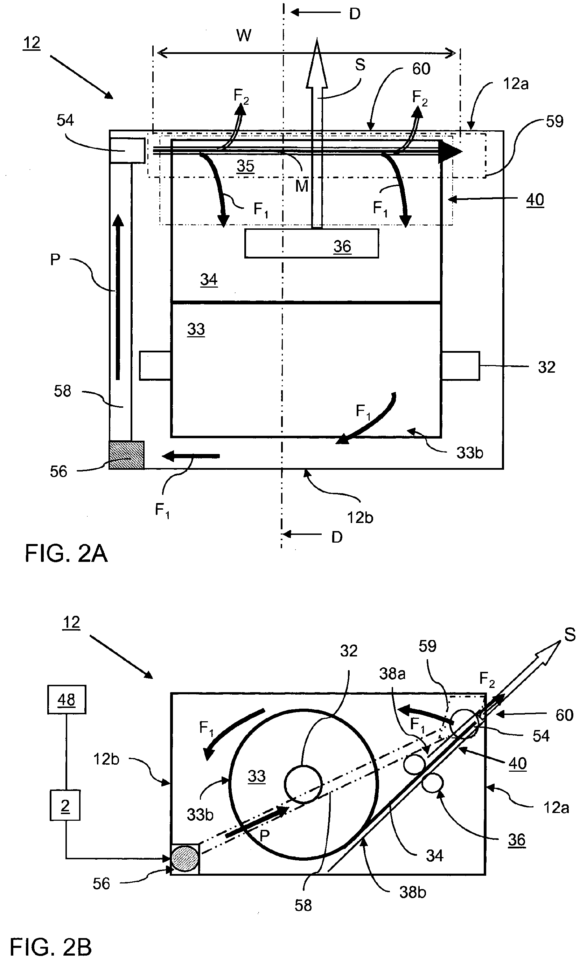

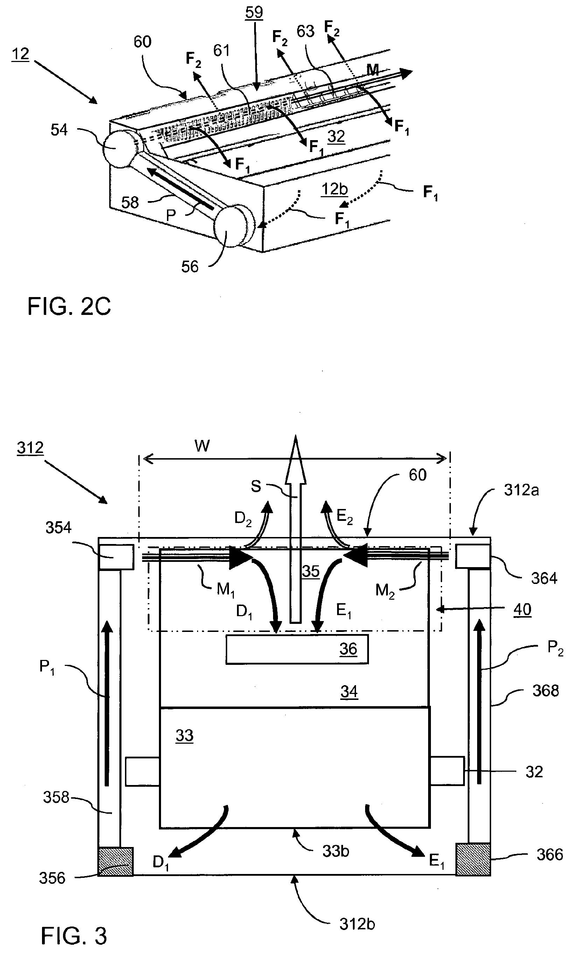

Fig. 2A shows a schematical plan view of a recording medium storage enclosure according to a first embodiment of the present invention. In a recording medium storage enclosure 12 a paper roll 33 is supported by a reel 32, wherein a web 34 is drawn-off from the paper roll 33 by means of a respectively associated pair of transport rollers 36 and fed in a feeding direction S through the feeding path 40 towards an exit opening of the recording medium storage enclosure 60. A leading edge of the web 35 is positioned adjacent to the exit opening 60.
In the recording medium storage enclosure 12 an air flow manifold 54 is arranged at the first end of the recording medium storage enclosure 12a. The air flow manifold 54 is operatively connected to a duct 58, which is operatively connected to an air flow source 56. The air flow source 56 is controlled by a control unit 2 (shown in Fig. 2B). In operation condition the air flow source 56 provides an air flow P along the duct 58 towards the air flow manifold 54.The air flow manifold 54 directs the air flow in a main air flow direction M adjacent to the exit opening 60, wherein the main air flow direction M is aligned substantially perpendicular to the feeding direction S of the web 34 through the exit opening 60. Attributes of the air flow M, such as a flow rate, flow velocity and a distance between the main air flow M and the exit opening 60, are suitably selected in order to extend the air flow M over substantially the width of the exit opening W. A distribution means 59 (also shown in Figure 2C) is arranged at the first end 12a of the recording medium storage enclosure in the main air flow M. The distribution means directs a first portion F₁ of the air flow M towards the second end of the recording medium storage enclosure 12b in order to circulate the first portion F₁ between the first end 12a and the second end 12b of the recording medium storage enclosure (as is indicated by arrows F₁). The circulation of the first portion F₁ between the first end 12a and the second end 12b is enhanced by the arrangement of the air flow source 56 at the second end 12b of the recording medium storage enclosure . The distribution means 59 further directs a second portion F₂ of the air flow M towards the exit opening 60. The second portion F₂ provides an overpressure inside the recording medium storage enclosure 12 adjacent to the exit opening 60 with respect to an ambient pressure outside the recording medium storage enclosure.
The first portion F₁ of the air flow provides that a micro climate, which is inside the recording medium storage enclosure 12, is made uniform. In case the humidity of the air at the first end of the recording medium storage enclosure 12a is higher than the humidity of the air at the second end 12b of the recording medium storage enclosure, the circulating first portion F₁ of the air flow reduces a difference in humidity of the air between the first end and the second end of the recording medium storage enclosure. As a result a leading edge 35 of the web, which is arranged inside the paper feed path 40 close to the first end 12a of the recording medium storage enclosure, will have a similar humidity compared to a peripheral surface portion 33b of the roll, which is arranged close to the second end 12b of the recording medium storage enclosure.

Fig. 2B shows a cross-sectional view of the recording medium storage enclosure along the line D-D of the embodiment of Fig. 2A. In Fig. 2B it is shown that the air flow source 56 is arranged at a lower side of the recording medium storage enclosure 12 at the second end 12b of the recording medium storage enclosure, while the air flow manifold 54 is arranged at an upper side of the recording medium storage enclosure 12 near the first end 12a of the recording medium storage enclosure. This arrangement of both the air flow source 56 and the air flow manifold 54 enhance the circulation of the air flow throughout the recording medium storage enclosure 12. Further it is shown that the air flow manifold 54 is arranged with respect to the paper feed path 40, such that the main air flow direction M is aligned with a lateral direction of the feed path 40 of the recording medium. In fact in Fig. 2B the air flow M is directed parallel to a common plane of the respectively associated pair of two guiding plates 38a, 38b, which enclose the feed path 40. A leading edge 35 of the web is arranged inside the feed path 40 close to the exit opening 60. The main air flow M is arranged inside the feed path 40 at one side of the web 34. It has been found that an air flow M at one side of the web 34 is sufficiently effective in reducing a gradient in humidity of the web 34. Alternatively the main air flow M may be arranged at both sides of the leading edge 35 of the web.

Fig. 2C illustrates an enlarged view of the distribution means of the first embodiment shown in Fig. 2A. The distribution means 59 comprises a plurality of grooves 61 distributed along the main air flow M path. The plurality of grooves 61 directs a first portion F₁ of the air flow towards the second end 12b of the recording medium storage enclosure. Furthermore the distribution means 59 comprises a plate having plurality of openings 63 distributed along the main air flow M path adjacent to the exit opening 60. The plurality of openings 63 directs a second portion F₂ of the air flow towards the exit opening 60. Alternatively a distance between the guiding plate 38a and the guiding plate 38b may suitably be selected (shown in Fig. 2B) in order to direct a second portion F₂ of the air flow towards the exit opening 60.

Fig. 3 shows a schematical plan view of a recording medium storage enclosure according to a second embodiment of the present invention. In Fig. 3A the recording medium storage enclosure 312 is shown. In the recording medium storage enclosure 312 a first air flow manifold 354 and a second air flow manifold 364 are arranged at opposite sides, respectively, of the first end 312a of the recording medium storage enclosure. The first air flow manifold 354 is operatively connected to a first duct 358, which is operatively connected to a first air flow source 356. The second air flow manifold 364 is operatively connected to a second duct 368, which is operatively connected to a second air flow source 366.

The first air flow source 356 and the second air flow source 366 are controlled by a control unit (not shown). In operation condition the first and second air flow source 356, 366 provide an air flow P₁, P₂ along the duct 358, 368 towards the air flow manifold 354, 364, respectively. The first and second air flow manifold 354, 364 are configured to provide an air flow in a first and second main air flow direction M₁, M₂, respectively, adjacent to the exit opening 60. The first and second main air flow direction M₁, M₂ are both aligned substantially perpendicular to the feeding direction S of the web 34 through the exit opening 60. The first main air flow direction M₁ is arranged substantially opposite to the second main air flow direction M₂, such that two main air flow directions encounter each other adjacent to the exit opening 60. Due to the interaction between the first and the second main air flow direction M₁, M₂, a first circulating portion D₁, E₁ of each of the air flows M₁, M₂ is directed towards the second end of the recording medium storage enclosure 312b. Likewise a second portion D₂, E₂ of each of the air flows M₁, M₂ is directed towards the exit opening 60. The second portion D₂, E₂ provides an overpressure inside the recording medium storage enclosure 312 adjacent to the exit opening 60 with respect to an ambient pressure outside the recording medium storage enclosure. The ratio between the volume of each of the first portions D₁, E₁ and each of the second portions D₂, E₂ may suitably be adjusted, e.g. by adjusting the attributes of the first and second main air flow direction M₁, M₂.

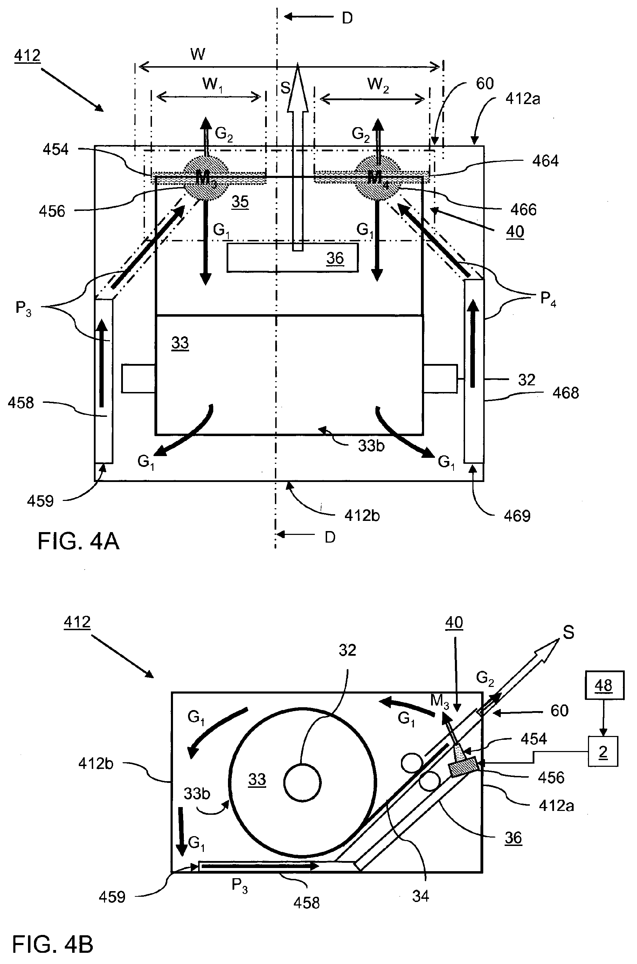

Fig. 4A shows a schematical plan view of a recording medium storage enclosure according to a third embodiment of the present invention. In Fig. 4A the recording medium storage enclosure 412 is shown. In the recording medium storage enclosure 412 a first air flow manifold 454 and a second air flow manifold 464 are arranged at the first end of the recording medium storage enclosure 412a below a feed path 40. The first air flow manifold 454 is operatively connected to a first air flow source 456, which is operatively connected to a first duct 458. The second air flow manifold 464 is operatively connected to a second air flow source 466, which is operatively connected to a second duct 468. An inlet portion of the first and second ducts 459, 469, respectively, is arranged at opposite sides, respectively, of a second end 412b of the recording medium storage enclosure.
The first and second air flow sources 456, 466 are controlled by a control unit 2 (shown in Fig. 4B). In operation condition the first and second air flow source 456, 466 provide an air flow P₃, P₄ along the duct towards the air flow manifolds 454, 464, respectively. The first and second air flow manifold 454, 464 are configured to direct an air flow in a first and second main air flow direction M₃, M₄, respectively, adjacent to the exit opening 60 (in the direction normal to the plane of Fig. 4A). The main air flow directions M₃, M₄ are both aligned substantially perpendicular to the feeding direction S of the web 34 through the exit opening 60. The first main air flow direction M₃ is arranged substantially parallel to the second main air flow direction M₄. The first and second main air flow direction M₃, M₄ extend over a part of the width of the exit opening W₁, W₂, respectively. The parts of the width W₁, W₂ are suitably selected in order to cooperatively cover a sufficient part of the width of the exit opening W.

Fig. 4B shows a cross-sectional view of the recording medium storage enclosure along the line D-D of the embodiment of Fig. 4A. A leading edge 35 of the web is positioned in the feed path 40 adjacent to the exit opening 60. Both first and second main air flow direction M₃, M₄ are directed towards a lower side of the feed path 40, thereby encountering a lower side of the leading edge 35 of the web. Attributes of the feed path 40, such as an open structure, is suitably selected to direct a circulating first portion G₁ between the first end 412a and the second end 412b of the recording medium storage enclosure and to direct a second portion G₂ towards the exit opening 60. Furthermore a position of the leading edge 35 of the web in the feed path 40 may be adjusted in order to adjust a ratio in volume between the first portion G₁ and the second portion G₂. For example, the leading edge 35 of the web may be positioned closer to the exit opening, thereby reducing the volume of the first portion G₁ and increasing the volume of the second portion G₂.

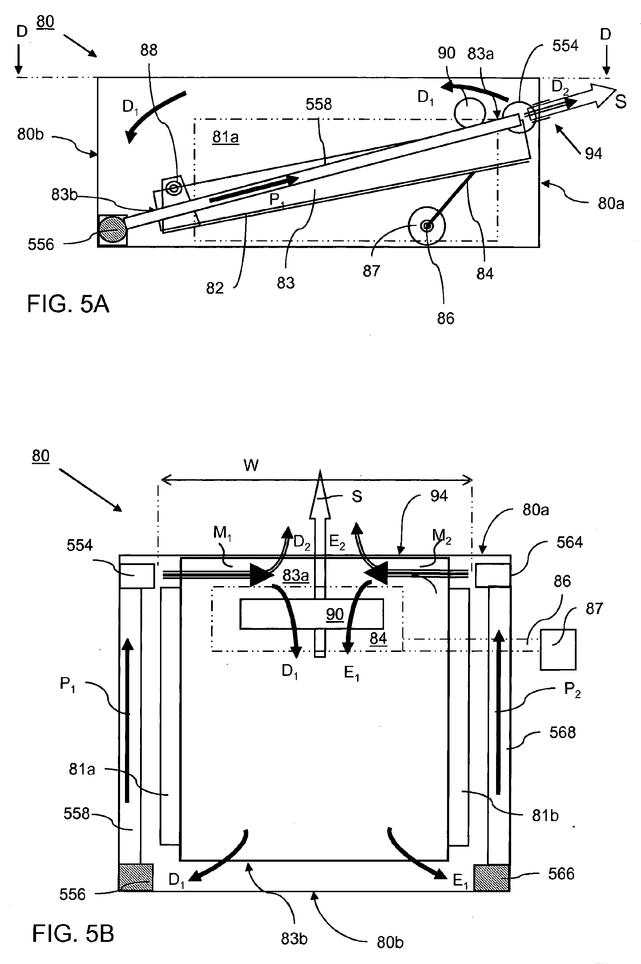

Fig. 5A shows a schematical side view of a recording medium storage enclosure according to a fourth embodiment of the present invention. In a cut sheet recording medium storage enclosure 80 a stack of cut sheets 83 is supported by a sheet loading plate 82. The stack of sheets 83 is aligned at two sides, each side being confined by a sheet side restriction 81 a, 81 b (the latter only being shown in Fig. 5B). The sheet loading plate 82 is lifted at a first end 80a of the recording medium storage enclosure by a lifter plate 84. The sheet loading plate 82 is rotatably supported at a second end 80b of the recording medium storage enclosure by a rotatable shaft 88. The lifter plate 84 is rotatably supported by a lifter drive shaft 86, which is rotated by a lifter drive gear 87.
The lifter plate 84 is positioned such that an upper cut sheet of the stack of sheets 83a is moved into contact with a pick upper roller 90. The pick up roller 90 is rotatably driven to feed the upper cut sheet of the stack of sheets 83a in a feeding direction, as indicated by arrow S, towards an exit opening 94 of the recording medium storage enclosure 80, which is arranged at the first end 80a of the recording medium storage enclosure.

Fig. 5B shows a plan view of the recording medium storage enclosure along the line D-D of the embodiment of Fig. 5A. In the recording medium storage enclosure 80 a first air flow manifold 545 and a second air flow manifold 565 are arranged at opposite sides, respectively, of the first end 80a of the recording medium storage enclosure. The first air flow manifold 545 is operatively connected to a first duct 558, which is operatively connected to a first air flow source 556. The second air flow manifold 565 is operatively connected to a second duct 568, which is operatively connected to a second air flow source 566.
The first air flow source 556 and the second air flow source 566 are controlled by a control unit (not shown). In operation condition the first and second air flow source 556, 566 provide an air flow P₁, P₂ along the duct 556, 566 towards the air flow manifold 545, 565, respectively. The first and second air flow manifold 545, 565 are configured to direct the air flow in a first and second main air flow direction M₁, M₂ adjacent to the exit opening 94, wherein the main air flow direction M₁, M₂ are both aligned substantially perpendicular to the feeding direction S of an upper cut sheet 83a through the exit opening 94. Each of the main air flow directions M₁, M₂ is aligned with a surface of the upper cut sheet 83a.
The first main air flow direction M₁ is arranged opposite to the second main air flow direction M₂, such that two main air flow directions encounter each other adjacent to the exit opening 94.
Due to the interaction between the first and the second main air flow direction M₁, M₂, a first circulating portion D₁, E₁ of each of the air flows M₁, M₂ is directed towards the second end 80b of the recording medium storage enclosure. Likewise a second portion D₂, E₂ of each of the air flows M₂ is directed towards the exit opening 94. The second portion D₂, E₂ provides an overpressure inside the recording medium storage enclosure 12 adjacent to the exit opening 94 with respect to an ambient pressure outside the recording medium storage enclosure. The ratio between the volume of each of the first portions D₁, E₁ and each of the second portions D₂, E₂ may suitably be adjusted, e.g. by adjusting the attributes of the first and second main air flow direction M₁, M₂.

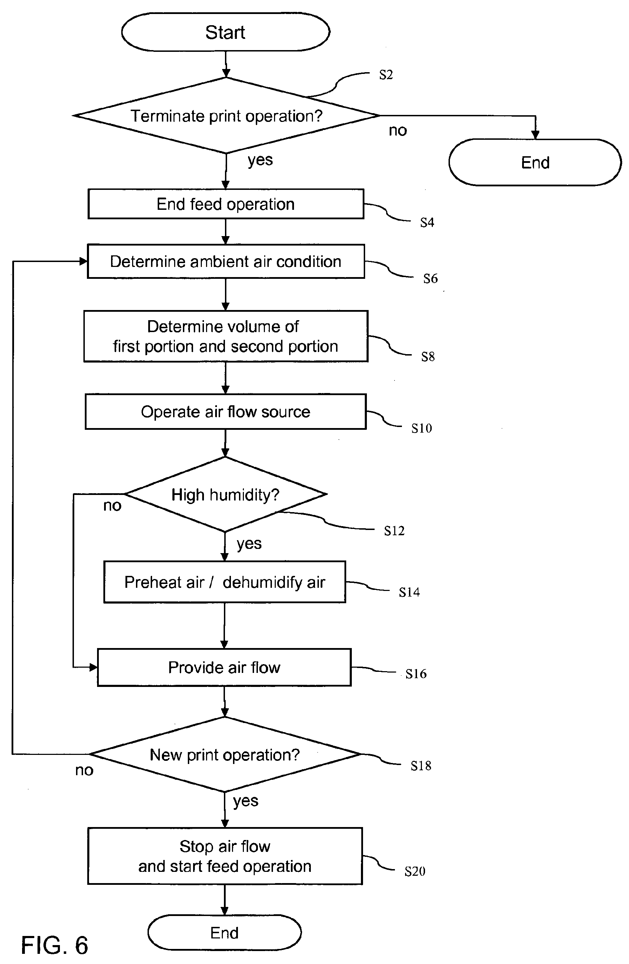

Fig. 6 shows a flow-chart of a method according to the present invention. The method illustrated here can be used in any of the first, second, third and fourth embodiments of the present invention (as shown in Fig. 2A - 5B). The steps of the method will be explained for a web based recording medium. The steps may be performed likewise for a stack of cut sheets.
In step S2 of the method it is judged whether a print operation is terminated. In case yes in step S4 a feed operation of the web is ended and the leading edge is retracted to the feed path 40 in the recording medium storage enclosure. In step S6 at least one attribute of the ambient air condition is determined, such as an ambient air pressure, an ambient air humidity and an ambient air temperature. The ambient air condition may be obtained from a sensor, such as humidity sensor 48. In step S8 a volume of a first circulating portion and a second portion is determined by a control unit based on the determined ambient air condition of step S6. In step S10 an air flow source is operated by the control unit in order to provide an air flow based on the volume of the first and second portion determined in step S8. In step S12 it is judged whether the ambient air humidity is high with respect to a threshold value, based on a determined ambient air condition of step S6. In case yes, in step S14 the air flow, which is provided by the air flow source inside the recording medium storage enclosure, is pre-heated or dehumidified. In step S16 the air flow is provided, in side the recording medium storage enclosure, wherein a first portion of the air flow is circulated and a second portion of the air flow is directed to the exit opening of the recording medium storage enclosure. Optionally, in case desired, a ratio between the volume of the first portion and the second portion may be adjusted in an additional step (not shown in Fig. 6), in the way as is described in the second and third embodiments. In step S18 it is judged whether a new print operation is started. In case yes, in step S20 the air flow in the recording medium storage enclosure is terminated by inactivating the air flow source and a leading edge of the web is transported through the exit opening towards the printing station. In case no, the steps S6 - S18 are repeated.

Detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. In particular, features presented and described in separate dependent claims may be applied in combination and any advantageous combination of such claims are herewith disclosed.
Further, the terms and phrases used herein are not intended to be limiting; but rather, to provide an understandable description of the invention. The terms "a" or "an", as used herein, are defined as one or more than one. The term plurality, as used herein, is defined as two or more than two. The term another, as used herein, is defined as at least a second or more. The terms including and/or having, as used herein, are defined as comprising (i.e., open language). The term coupled, as used herein, is defined as connected, although not necessarily directly.
The invention being thus described, it will be obvious that the same may be varied in many ways within the scope of the following claims.

## Claims

1. A method for conditioning a recording medium storage enclosure (12, 80, 312, 412) in a printing system, the recording medium storage enclosure (12, 80, 312, 412) comprising an exit opening (60, 94) being arranged at a first end (12a, 80a, 312a, 412a) of the recording medium storage enclosure (12, 80, 312, 412), which exit opening (60, 94) is configured for releasing a portion of a recording medium (34, 83) towards a printing station (18) of the printing system, the method comprising the step of:
a) providing an air flow inside the recording medium storage enclosure (12, 80, 312, 412) in a main air flow direction (M, M₁, M₂, M₃, M₄) adjacent to the exit opening (60, 94), wherein the main air flow direction (M, M₁, M₂, M₃, M₄) is aligned along a direction of the exit opening (60, 94), which is substantially perpendicular to a feeding direction of a recording medium (S) through the exit opening (60, 94);
**characterised by** the steps of:
b) circulating a first portion of the air flow (F₁, D₁, E₁, G₁) provided in step a) within the recording medium storage enclosure (12, 80, 312, 412) between the first end (12a, 80a, 312a, 412a) and the second end (12b, 80b, 312b, 412b) of the recording medium storage enclosure (12, 80, 312, 412) opposite of the first end (12a, 80a, 312a, 412a); and
c) directing a second portion of the air flow (F₂, D₂, E₂, G₂) provided in step a) towards the exit opening (60, 94) in order to provide an overpressure inside the recording medium storage enclosure (12, 80, 312, 412) adjacent to the exit opening (60, 94) with respect to an ambient pressure outside the recording medium storage enclosure (12, 80, 312, 412).

2. The method according to claim 1, wherein step a) further comprises aligning the main air flow direction (M, M₁, M₂, M₃, M₄) along a feed path of the recording medium (40), which feed path (40) is configured for conveying the recording medium (34, 83) towards the exit opening (60, 94).

3. The method according to claim 1, wherein the first portion of the air flow (F₁, D₁, E₁, G₁) of step b) is larger than the second portion of the air flow (F₂, D₂, E₂, G₂) of step c).

4. The method according to claim 1, wherein the air of the air flow provided in step a) is pre-heated above ambient air temperature prior to step a).

5. The method according to claim 1, wherein the air of the air flow provided in step a) is dehumidified with respect to an ambient air humidity prior to step a).

6. The method according to claim 1, wherein the method further comprises step d) feeding a portion of the recording medium (34, 83) through the exit opening (60, 94) of the recording medium storage enclosure (12, 80, 312, 412) towards the print station (18) of the printing system, and wherein step a) is performed after step d) has ended.

7. A printing system comprising a printing station (18) and a recording medium storage enclosure (12, 80, 312, 412), wherein the recording medium storage enclosure (12, 80, 312, 412) comprises:
a) an exit opening (60, 94) arranged at a first end (12a, 80a, 312a, 412a) of the recording medium storage enclosure (12, 80, 312, 412) for releasing a portion of a recording medium (34, 83) towards the printing station (18) of the printing system;
b) an air flow source (56, 356, 456, 466, 556) for providing a circulating air flow inside the recording medium storage enclosure (12, 80, 312, 412) between the first end (12a, 80a, 312a, 412a) and the second end (12b, 80b, 312b, 412b) of the recording medium storage enclosure (12, 80, 312, 412) opposite of the first end (12a, 80a, 312a, 412a); and
c) an air flow manifold (54, 354, 364, 454, 464, 554) for directing the air flow at the first end (12a, 80a, 312a, 412a) of the recording medium storage enclosure (12, 80, 312, 412) in a main air flow direction (M, M₁, M₂, M₃, M₄) adjacent to the exit opening (60, 94), wherein the main air flow direction (M, M₁, M₂, M₃, M₄) is aligned along a direction of the exit opening (60, 94), which is substantially perpendicular to a feeding direction (S) of a recording medium through the exit opening (60, 94); **characterised by**
d) a distribution means (59, 40) arranged at the first end (12a, 80a, 312a, 412a) for directing a circulating first portion of the air flow (F₁, D₁, E₁, G₁) from the first end (12a, 80a, 312a, 412a) to the second end (12b, 80b, 312b, 412b) of the recording medium storage enclosure (12, 80, 312, 412) and directing a second portion of the air flow (F₂, D₂, E₂, G₂) towards the exit opening (60, 94) in order to provide an overpressure inside the recording medium storage enclosure (12, 80, 312, 412) adjacent to the exit opening (60, 94) with respect to an ambient pressure outside the recording medium storage enclosure (12, 80, 312, 412),
the printing system further comprises a control unit (2) for controlling the air flow source.

8. The printing system according to claim 7, wherein the air flow manifold (54, 354, 364, 454, 464, 554) is arranged for aligning the main air flow direction (M, M₁, M₂, M₃, M₄) along a feed path (40) configured for conveying the recording medium (34, 83) towards the exit opening (60, 94).

9. The printing system according to claim 7, wherein the printing system further comprises a sensor (48) for sensing an ambient air condition and wherein the control unit (2) controls the air flow source (56, 356, 456, 466, 556) based on a sensor signal provided by the sensor (48) to the control unit (2) indicating the ambient air condition.

10. The printing system according to claim 7, wherein the recording medium storage enclosure (12, 80, 312, 412) further comprises a duct (58, 358, 368, 458, 468, 558) arranged for channeling the air flow from the second end (12b, 80b, 312b, 412b) of the recording medium storage enclosure (12, 80, 312, 412) towards the air flow manifold (54, 354, 364, 454, 464, 554).

11. The printing system according to claim 7, wherein the recording medium storage enclosure (12, 80, 312, 412) further comprises a recording medium supporting means (32, 82) for supporting the recording medium (34, 83), being arranged between the first end (12a, 80a, 312a, 412a) and the second end (12b, 80b, 312b, 412b) of the recording medium storage enclosure (12, 80, 312, 412).

12. The printing system according to claim 7, wherein recording medium storage enclosure (12, 80, 312, 412) further comprises a feed control system (46) for in operation feeding a portion of the recording medium (34, 83) in the recording medium storage enclosure (12, 80, 312, 412) towards the printing station (18) of the printing system, and wherein the control unit (2) controls the air flow source (56, 356, 456, 466, 556) based on the feeding operation by the feed control system (46).

13. An air flow kit for conditioning a recording medium storage enclosure (12, 80, 312, 412), the recording medium storage enclosure (12, 80, 312, 412) comprising an exit opening (60, 94) for releasing a portion of a recording medium (34, 83) towards the printing station (18) of the printing system, wherein the air flow kit comprises:
a) an air flow source (56, 356, 456, 466, 556) for providing a circulating air flow inside the recording medium storage enclosure (12, 80, 312, 412) between a first end (12a, 80a, 312a, 412a) of the recording medium storage enclosure (12, 80, 312, 412) adjacent to the exit opening (60, 94) and a second end (12b, 80b, 312b, 412b) of the recording medium storage enclosure (12, 80, 312, 412) opposite of the first end (12a, 80a, 312a, 412a); and
b) an air flow manifold (54, 354, 364, 454, 464, 554) for directing the air flow at the first end (12a, 80a, 312a, 412a) of the recording medium storage enclosure (12, 80, 312, 412) in a main air flow direction (M, M₁, M₂, M₃, M₄) adjacent to the exit opening (60, 94);
and **characterised by** comprising further:
c) a distribution means (59, 40) for directing a circulating first portion of the air flow (F₁, D₁, E₁, G₁) from the first end (12a, 80a, 312a, 412a) to the second end (12b, 80b, 312b, 412b) of the recording medium storage enclosure (12, 80, 312, 412) and directing a second portion of the air flow (F₂, D₂, E₂, G₂) towards the exit opening (60, 94) in order to provide an overpressure inside the recording medium storage enclosure (12, 80, 312, 412) adjacent to the exit opening (60, 94) with respect to an ambient pressure outside the recording medium storage enclosure (12, 80, 312, 412); and
d) a duct (58, 358, 368, 458, 468, 558) arranged for channeling the air flow from the second end (12b, 80b, 312b, 412b) of the recording medium storage enclosure (12, 80, 312, 412) towards the air flow manifold (54, 354, 364, 454, 464, 554).

14. A process of providing an air flow kit according to claim 13 in a recording medium storage enclosure (12, 80, 312, 412) for conditioning the recording medium storage enclosure (12, 80, 312, 412) including:
a) arranging the air flow source (56, 356, 456, 466, 556) between the first end (12a, 80a, 312a, 412a) and the second end (12b, 80b, 312b, 412b) of the recording medium storage enclosure (12, 80, 312, 412) and connecting the air flow source (56, 556) to a control unit (2);
b) arranging the air flow manifold (54, 354, 364, 454, 464, 554) at the first end (12a, 80a, 312a, 412a) of the recording medium storage enclosure (12, 80, 312, 412) such that, in operation of the air flow source (56, 356, 456, 466, 556), an air flow is directed in a main air flow direction (M, M₁, M₂, M₃, M₄) adjacent to the exit opening (60, 94);
c) arranging the distribution means (59, 40) in a position along the main air flow direction (M) adjacent to the exit opening (60, 94);
d) arranging the duct (58, 358, 368, 458, 468, 558) between the second end (12b, 80b, 312b, 412b) of the recording medium storage enclosure (12, 80, 312, 412) and the air flow manifold (54, 354, 364, 454, 464, 554) at the first end (12a, 80a, 312a, 412a) of the recording medium storage enclosure (12, 80, 312, 412); and
e) coupling the air flow source (56, 356, 456, 466, 556) to the duct (58, 358, 368, 458, 468, 558) and to the air flow manifold (54, 354, 364, 454, 464, 554), such that, in operation of the air flow source (56, 356, 456, 466, 556), the air flow is moved from the second end (12b, 80b, 312b, 412b) to the air flow manifold (54, 354, 364, 454, 464, 554) at the first end (12a, 80a, 312a, 412a) of the recording medium storage enclosure (12, 80, 312, 412).

## Patentansprüche

1. Ein Verfahren zum Konditionieren eines Lagerbehältnisses (12, 80, 312, 412) für Aufzeichnungsmedien in einem Druckersystem, wobei das Lagerbehältnis (12, 80, 312, 412) für Aufzeichnungsmedien eine Auslassöffnung (60, 94) aufweist, die an einem ersten Ende (12a, 80a, 312a, 412a) des Lagerbehältnisses (12, 80, 312, 412) für Aufzeichnungsmedien angeordnet ist, wobei die Auslassöffnung (60, 94) dazu konfiguriert ist, einen Teil eines Aufzeichnungsmediums (34, 83) in Richtung auf eine Druckerstation (18) des Druckersystems auszugeben, welches Verfahren den folgenden Schritt umfasst:
a) Bereitstellen einer Luftströmung im Inneren des Lagerbehältnisses (12, 80, 312, 412) für Aufzeichnungsmedien in einer Haupt-Luftströmungsrichtung (M, M₁, M₂, M₃, M₄) benachbart zu der Auslassöffnung (60, 94), wobei die Haupt-Luftströmungsrichtung (M, M₁, M₂, M₃, M₄) längs einer Richtung der Auslassöffnung (60, 94) ausgerichtet ist, die im wesentlichen rechtwinklig zu einer Transportrichtung eines Aufzeichnungsmediums (S) durch die Auslassöffnung (60, 94) ist; **gekennzeichnet durch** die folgenden Schritte:
b) Umwälzen eines ersten Teils der Luftströmung (F₁, D₁, E₁, G₁), die in Schritt a) bereitgestellt wurde, im Inneren des Lagerbehältnisses (12, 80, 312, 412) für Aufzeichnungsmedien zwischen dem ersten Ende (12a, 80a, 312a, 412a) und dem zweiten Ende (12b, 80b, 312b, 412b) des Lagerbehältnisses (12, 80, 312, 412) für Aufzeichnungsmedien, das dem ersten Ende (12a, 80a, 312a, 412a) entgegengesetzt ist; und
c) Lenken eines zweiten Teils der Luftströmung (F₂, D₂, E₂, G₂), die in Schritt a) bereitgestellt wurde, in Richtung auf die Auslassöffnung (60, 94), um im Inneren des Lagerbehältnisses (12, 80, 312, 412) für Aufzeichnungsmedien, angrenzend an die Auslassöffnung (60, 94), einen Überdruck im Verhältnis zu einem Umgebungsdruck außerhalb des Lagerbehältnisses (12, 80, 312, 412) für Aufzeichnungsmedien zu erzeugen.

2. Das Verfahren nach Anspruch 1, bei dem Schritt a) weiterhin die Ausrichtung der Haupt-Luftströmungsrichtung (M, M₁, M₂, M₃, M₄,) längs eines Transportpfades (40) für das Aufzeichnungsmedium einschließt, wobei der Transportpfad (40) dazu konfiguriert ist, das Aufzeichnungsmedium (34, 83) in Richtung auf die Auslassöffnung (60, 94) zu transportieren.

3. Das Verfahren nach Anspruch 1, bei dem der erste Teil der Luftströmung (F₁, D₁, E₁, G₁) in Schritt b) größer ist als der zweite Teil der Luftströmung (F₂, D₂, E₂, G₂) in Schritt c).

4. Das Verfahren nach Anspruch 1, bei dem die Luft der in Schritt a) bereitgestellten Luftströmung vor dem Schritt a) auf über die Umgebungslufttemperatur vorerhitzt wird.

5. Das Verfahren nach Anspruch 1, bei dem die Luft der in Schritt a) bereitgestellten Luftströmung vor dem Schritt a) gegenüber einer Umgebungsluftfeuchte entfeuchtet wird.

6. Das Verfahren nach Anspruch 1, welches Verfahren weiterhin den Schritt d) des Transports eines Teils des Aufzeichnungsmediums (34, 83) durch die Auslassöffnung (60, 94) des Lagerbehältnisses (12, 80, 312, 412) für Aufzeichnungsmedien in Richtung auf die Druckerstation (18) des Druckersystems umfasst, und wobei Schritt a) nach der Beendigung des Schrittes d) ausgeführt wird.

7. Ein Druckersystem mit einer Druckerstation (18) und einem Lagerbehältnis (12, 80, 312, 412) für Aufzeichnungsmedien, wobei das Lagerbehältnis (12, 80, 312, 412) für Aufzeichnungsmedien aufweist:
a) eine Auslassöffnung (60, 94), die an einem ersten Ende (12a, 80a, 312a, 412a) des Lagerbehältnisses (12, 80, 312, 412) für Aufzeichnungsmedien angeordnet ist, zur Ausgabe eines Teils eines Aufzeichnungsmediums (34, 83) in Richtung auf die Druckerstation (18) des Druckersystems;
b) eine Luftströmungsquelle (96, 356, 456, 466, 556) zum Bereitstellen einer Umluftströmung im Inneren des Lagerbehältnisses (12, 80, 312, 412) für Auf zeichnungsmedien zwischen dem ersten Ende (12a, 80a, 312a, 412a) und dem zweiten Ende (12b, 80b, 312b, 412b) des Lagerbehältnisses (12, 80, 312, 412) für Aufzeichnungsmedien, das dem ersten Ende (12a, 80a, 312a, 412a) entgegengesetzt ist; und
c) einen Luftströmungsverteiler (54, 354, 364, 454, 464, 554) zum Lenken der Luftströmung an dem ersten Ende (12a, 80a, 312, 412a) des Lagerbehältnisses (12, 80, 312, 412) für Aufzeichnungsmedien in einer Haupt-Luftströmungsrichtung (M, M₁, M₂, M₃, M₄) angrenzend an die Auslassöffnung (60, 94), wobei die Haupt-Luftströmungsrichtung (M, M₁, M₂, M₃, M₄) längs einer Richtung der Auslassöffnung (60, 94) ausgerichtet ist, die im wesentlichen rechtwinklig zu einer Transportrichtung (S) eines Aufzeichnungsmediums durch die Auslassöffnung (60, 94) ist, **gekennzeichnet durch**:
d) eine an dem ersten Ende (12a, 80a, 312a, 412a) angeordnete Verteileinrichtung (59, 40) zum Lenken eines umgewälzten ersten Teils der Luftströmung (F₁, D₁, E₁, G₁) von dem ersten Ende (12a, 80a, 312a, 412a) zu dem zweiten Ende (12b, 80b, 312b, 412b) des Lagerbehältnisses (12, 80, 312, 412) für Aufzeichnungsmedien und zum Lenken eines zweiten Teils der Luftströmung (F₂, D₂, E₂, G₂) in Richtung auf die Auslassöffnung (60, 94), um im Inneren des Lagerbehältnisses (12, 80, 312, 412) angrenzend an die Auslassöffnung (60, 94) einen Überdruck im Verhältnis zu einem Umgebungsdruck außerhalb des Lagerbehältnisses (12, 80, 312, 412) für Aufzeichnungsmedien zu erzeugen,
wobei das Druckersystem weiterhin eine Steuereinheit (2) zur Steuerung der Luftströmungsquelle aufweist.

8. Das Druckersystem nach Anspruch 7, bei dem der Strömungsverteiler (54, 354, 364, 454, 464, 554) dazu eingerichtet ist, die Haupt-Luftströmungsrichtung (M, M₁, M₂, M₃, M₄) entlang eines Transportpfades (40) auszurichten, der dazu konfiguriert ist, das Aufzeichnungsmedium (34, 83) in Richtung auf die Auslassöffnung (60, 94) zu transportieren.

9. Das Druckersystem nach Anspruch 7, bei dem das Druckersystem weiterhin einen Sensor (48) zum Erfassen eines Zustands der Umgebungsluft aufweist und bei dem die Steuereinheit (2) die Luftströmungsquelle (56, 356, 456, 466, 556) auf der Grundlage eines Sensorsignals ansteuert, das der Steuereinheit (2) von dem Sensor (48) zugeführt wird und den Zustand der Umgebungsluft angibt.

10. Das Druckersystem nach Anspruch 7, bei dem das Lagerbehältnis ( 12, 80, 312, 412) für Aufzeichnungsmedien weiterhin eine Leitung (58, 358, 368, 458, 468, 558) aufweist, die dazu eingerichtet ist, die Luftströmung von dem zweiten Ende (12b, 80b, 312b, 412b) des Lagerbehältnisses (12, 80, 312, 412) für Aufzeichnungsmedien in Richtung auf den Luftströmungsverteiler (54, 354, 364, 454, 464, 554) zu kanalisieren.

11. Das Druckersystem nach Anspruch 7, bei dem das Lagerbehältnis (12, 80, 312, 412) für Aufzeichnungsmedien weiterhin eine Stützeinrichtung (32, 82) für Aufzeichnungsmedien aufweist, zum Abstützen des Aufzeichnungsmediums (34, 83), welche Stützeinrichtung zwischen dem ersten Ende (12a, 80a, 312, 412a) und dem zweiten Ende (12b, 80b, 312b, 412b) des Lagerbehältnisses (12, 80, 312, 412) für Aufzeichnungsmedien angeordnet ist.

12. Das Druckersystem nach Anspruch 7, bei dem das Lagerbehältnis (12, 80, 312, 412) für Aufzeichnungsmedien weiterhin ein Transportsteuersystem (46) aufweist, das dazu dient, im Betrieb einen Teil des Aufzeichnungsmediums (34, 83) in dem Lagerbehältnis (12, 80, 312, 412) für Aufzeichnungsmedien in Richtung auf die Druckerstation (18) des Druckersystems zu transportieren, und wobei die Steuereinheit (2) die Luftströmungsquelle (56, 356, 456, 466, 556) auf der Grundlage des Transportbetriebs des Transportsteuersystems (46) ansteuert.

13. Eine Luftströmungsausrüstung zum Konditionieren eines Lagerbehältnisses (12, 80, 312, 412) für Aufzeichnungsmedien, welches Lagerbehältnis (12, 80, 312, 412) für Aufzeichnungsmedien eine Auslassöffnung (60, 94) zum Ausgeben eines Teils eines Aufzeichnungsmediums (34, 83) in Richtung auf die Druckerstation (18) des Druckersystems aufweist, wobei die Luftströmungsausrüstung aufweist:
a) eine Luftströmungsquelle (96, 356, 456, 466, 556) zum Bereitstellen einer Umluftströmung im Inneren des Lagerbehältnisses (12, 80, 312, 412) für Auf zeichnungsmedien zwischen dem ersten Ende (12a, 80a, 312a, 412a) und dem zweiten Ende (12b, 80b, 312b, 412b) des Lagerbehältnisses (12, 80, 312, 412) für Aufzeichnungsmedien, das dem ersten Ende (12a, 80a, 312a, 412a) entgegengesetzt ist; und
b) einen Luftströmungsverteiler (54, 354, 364, 454, 464, 554) zum Lenken der Luftströmung an dem ersten Ende (12a, 80a, 312, 412a) des Lagerbehältnisses (12, 80, 312, 412) für Aufzeichnungsmedien in einer Haupt-Luftströmungsrichtung (M, M₁, M₂, M₃, M₄) angrenzend an die Auslassöffnung (60, 94), und **dadurch gekennzeichnet, dass** sie weiterhin aufweist:
c) eine Verteileinrichtung (59, 40) zum Lenken eines umgewälzten ersten Teils der Luftströmung (F₁, D₁, E₁, G₁) von dem ersten Ende (12a, 80a, 312a, 412a) zu dem zweiten Ende (12b, 80b, 312b, 412b) des Lagerbehältnisses (12, 80, 312, 412) für Aufzeichnungsmedien und zum Lenken eines zweiten Teils der Luftströmung (F₂, D₂, E₂, G₂) in Richtung auf die Auslassöffnung (60, 94), um im Inneren des Lagerbehältnisses (12, 80, 312, 412) angrenzend an die Auslassöffnung (60, 94) einen Überdruck im Verhältnis zu einem Umgebungsdruck außerhalb des Lagerbehältnisses (12, 80, 312, 412) für Aufzeichnungsmedien zu erzeugen, und
d) eine Leitung (58, 358, 368, 458, 468, 558), die dazu eingerichtet ist, die Luftströmung von dem zweiten Ende (12b, 80b, 312b, 412b) des Lagerbehältnisses (12, 80, 312, 412) für Aufzeichnungsmedien in Richtung auf den Luftströmungsverteiler (54, 354, 364, 454, 464, 554) zu kanalisieren.

14. Ein Verfahren zum Bereitstellen einer Luftströmungsausrüstung nach Anspruch 13 in einem Lagerbehältnis (12, 80, 312, 412) für Aufzeichnungsmedien, zum Konditionieren des Lagerbehältnisses (12, 80, 312, 412) für Aufzeichnungsmedien, mit:
a) Anordnen der Luftströmungsquelle (56, 356, 456, 466, 556) zwischen dem ersten Ende (12a, 80a, 312a, 412a) und dem zweiten Ende (12b, 80b, 312b, 412b) des Lagerbehältnisses (12, 80, 312, 412) für Aufzeichnungsmedien, und Verbinden der Luftströmungsquelle (56, 556) mit einer Steuereinheit (2);
b) Anordnen des Luftströmungsverteilers (54, 354, 364, 454, 464, 554) an dem ersten Ende (12a, 80a, 312a, 412a) des Lagerbehältnisses (12, 80, 312, 412) für Aufzeichnungsmedien, derart, dass im Betrieb der Luftströmungsquelle (56, 356, 456, 466, 556) eine Luftströmung in einer Haupt-Luftströmungsrichtung (M, M₁, M₂, M₃, M₄) angrenzend an die Auslassöffnung (60, 94) gelenkt wird;
c) Anordnen der Verteileinrichtung (59, 40) in einer Position entlang der Haupt-Luftströmungsrichtung (M) angrenzend an die Auslassöffnung (60, 94);
d) Anordnen der Leitung (58, 358, 368, 458, 468, 558) zwischen dem zweiten Ende (12b, 80b, 312b, 412b) des Lagerbehältnisses (12, 80, 312, 412) für Aufzeichnungsmedien und dem Luftströmungsverteiler (54, 354, 364, 454, 464, 554) an dem ersten Ende (12a, 80a, 312a, 412a) des Lagerbehältnisses (12, 80, 312, 412) für Auf zeichnungsmedien; und
d) Ankuppeln der Luftströmungsquelle (56, 356, 456, 466, 556) an die Leitung (58, 358, 368, 458, 468, 558) und an den Luftströmungsverteiler (54, 354, 364, 454, 464, 554) derart, dass im Betrieb der Luftströmungsquelle (56, 356, 456, 466, 556) die Luftströmung von dem zweiten Ende (12b, 80b, 312b, 412b) zu dem Luftströmungsverteiler (54, 354, 364, 454, 464, 554) an dem ersten Ende (12a, 80a, 312a, 412a) des Lagerbehältnisses (12, 80, 312, 412) für Aufzeichnungsmedien bewegt wird.

## Revendications

1. Procédé pour le conditionnement d'une enceinte de stockage de support d'enregistrement (12, 80, 312, 412) dans un système d'impression, l'enceinte de stockage de support d'enregistrement (12, 80, 312, 412) comprenant une ouverture de sortie (60, 94) étant agencée à une première extrémité (12a, 80a, 312a, 412a) de l'enceinte de stockage de support d'enregistrement (12, 80, 312, 412), laquelle ouverture de sortie (60, 94) est configurée pour libérer une partie d'un support d'enregistrement (34, 83) vers un poste d'impression (18) du système d'impression, le procédé comprenant l'étape de :
a) fourniture d'un flux d'air dans l'enceinte de stockage de support d'enregistrement (12, 80, 312, 412) dans une direction de flux d'air principale (M, M₁, M₂, M₃, M₄ ) adjacente à l'ouverture de sortie (60 ; 94), dans lequel la direction de flux d'air principale (M, M₁, M₂, M₃, M₄) est alignée le long d'une direction de l'ouverture de sortie (60, 94) qui est sensiblement perpendiculaire à une direction d'amenée d'un support d'enregistrement (S) par l'ouverture de sortie (60, 94) ;
**caractérisé par** les étapes de :
b) circulation d'une première partie du flux d'air (F₁, D₁, E₁, G₁) prévu à l'étape a) dans l'enceinte de stockage de support d'enregistrement (12, 80, 312, 412) entre la première extrémité (12a, 80a, 312a, 412a) et la seconde extrémité (12b, 80b, 312b, 412b) de l'enceinte de stockage de support de stockage (12, 80, 312, 412) en regard de la première extrémité (12a, 80a, 312a, 421a) ; et
c) direction d'une seconde partie du flux d'air (F₂, D₂, E₂, G₂) prévu à l'étape a) vers l'ouverture de sortie (60, 94) afin de fournir une surpression dans l'enceinte de stockage de support d'enregistrement (12, 80, 312, 412) adjacente à l'ouverture de sortie (60, 94) par rapport à une pression ambiante en dehors de l'enceinte de stockage de support d'enregistrement (12, 80, 312, 412).

2. Procédé selon la revendication 1, dans lequel l'étape a) comprend en outre l'alignement de la direction de flux d'air principale (M, M₁, M₂, M₃, M₄) le long d'une voie d'alimentation du support d'enregistrement (40), laquelle voie d'alimentation (40) est configurée pour transporter le support d'enregistrement (34, 83) vers l'ouverture de sortie (60, 94).

3. Procédé selon la revendication 1, dans lequel la première partie du flux d'air (F₁, D₁, E₁, G₁) de l'étape b) est plus grande que la seconde partie du flux d'air (F₂, D₂, E₂, G₂) de l'étape c) .

4. Procédé selon la revendication 1, dans lequel l'air du flux d'air prévu à l'étape a) est préchauffé au-dessus de la température de l'air ambiant avant l'étape a).

5. Procédé selon la revendication 1, dans lequel l'air du flux d'air prévu à l'étape a) est déshumidifié par rapport à une humidité d'air ambiant avant l'étape a).

6. Procédé selon la revendication 1, dans lequel le procédé comprend en outre l'étape d) alimentant une partie du support d'enregistrement (34, 83) par l'ouverture de sortie (60, 94) de l'enceinte de stockage de support d'enregistrement (12, 80, 312, 412) vers le poste d'impression (18) du système d'impression et dans lequel l'étape a) est réalisée après la fin de l'étape d).

7. Système d'impression comprenant un poste d'impression (18) et une enceinte de stockage de support d'enregistrement (12, 80, 312, 412), dans lequel l'enceinte de stockage de support d'enregistrement (12, 80, 312, 412) comprend :
a) une ouverture de sortie (60, 94) agencée à une première extrémité (12a, 80a, 312a, 412a) de l'enceinte de stockage de support d'enregistrement (12, 80, 312, 412) pour la libération d'une partie d'un support d'enregistrement (34, 83) vers le poste d'impression (18) du système d'impression ;
b) une source de flux d'air (56, 356, 456, 466, 556) pour la fourniture d'un flux d'air de circulation dans l'enceinte de stockage de support d'enregistrement (12, 80, 312, 412) entre la première extrémité (12a, 80a, 312a, 412a) et la seconde extrémité (12b, 80b, 312b, 412b) de l'enceinte de stockage de support d'enregistrement (12, 80, 312, 412) en regard de la première extrémité (12a, 80a, 312a, 412a) ; et
c) un collecteur de flux d'air (54, 354, 364, 454, 464, 554) pour la direction du flux d'air à la première extrémité (12a, 80a, 312a, 412a) de l'enceinte de stockage de support d'enregistrement (12, 80, 312, 412) dans une direction de flux d'air principale (M, M₁, M₂, M₃, M₄) adjacente à l'ouverture de sortie (60, 94), dans lequel la direction de flux d'air principale (M, M₁, M₂, M₃, M₄) est alignée le long d'une direction de l'ouverture de sortie (60, 94) qui est sensiblement perpendiculaire à une direction d'alimentation (S) d'un support d'enregistrement par l'ouverture de sortie (60, 94) ; **caractérisé par**
d) un moyen de distribution (59, 40) agencé à la première extrémité (12a, 80a, 312a, 412a) pour la direction d'une première partie de circulation du flux d'air (F₁, D₁, E₁, G₁) de la première extrémité (12a, 80a, 312a, 412a) à la seconde extrémité (12b, 80b, 312b, 412b) de l'enceinte de stockage de support d'enregistrement (12, 80, 312, 412) et la direction d'une seconde partie du flux d'air (F₂, D₂, E₂, G₂) vers l'ouverture de sortie (60, 94) afin de fournir une surpression dans l'enceinte de stockage de support d'enregistrement (12, 80, 312, 412) adjacente à l'ouverture de sortie (60, 94) par rapport à une pression ambiante à l'extérieur de l'enceinte de stockage de support d'enregistrement (12, 80, 312, 412),
le système d'impression comprend en outre une unité de commande (2) pour la commande de la source de flux d'air.

8. Système d'impression selon la revendication 7, dans lequel le collecteur de flux d'air (54, 354, 364, 454, 464, 554) est agencé pour aligner la direction de flux d'air principale (M, M₁, M₂, M₃, M₄) le long d'une voie d'alimentation (40) configurée pour transporter le support d'enregistrement (34, 83) vers l'ouverture de sortie (60, 94).

9. Système d'impression selon la revendication 7, dans lequel le système d'impression comprend en outre un capteur (48) pour détecter une condition d'air ambiant et dans lequel l'unité de commande (2) commande la source de flux d'air (56, 356, 456, 466, 556) sur la base d'un signal de capteur prévu par le capteur (48) à l'unité de commande (2) indiquant la condition d'air ambiant.

10. Système d'impression selon la revendication 7, dans lequel l'enceinte de stockage de support d'enregistrement (12, 80, 312, 412) comprend en outre un conduit (58, 358, 368, 458, 468, 558) agencé pour l'acheminement du flux d'air de la seconde extrémité (12b, 80b, 312b, 412b) de l'enceinte de stockage de support d'enregistrement (12, 80, 312, 412) vers le collecteur de flux d'air (54, 354, 364, 454, 464, 554).

11. Système d'impression selon la revendication 7, dans lequel l'enceinte de stockage de support d'enregistrement (12, 80, 312, 412) comprend en outre un moyen de support de support d'enregistrement (32, 82) pour supporter le support d'enregistrement (34, 83), étant agencé entre la première extrémité (12a, 80a, 312a, 412a) et la seconde extrémité (12b, 80b, 312b, 412b) de l'enceinte de stockage de support d'enregistrement (12, 80, 312, 412).

12. Système d'impression selon la revendication 7, dans lequel l'enceinte de stockage de support d'enregistrement (12, 80, 312, 412) comprend en outre un système de commande d'alimentation (46) pour alimenter en fonctionnement une partie du support d'enregistrement (34, 83) dans l'enceinte de stockage de support d'enregistrement (12, 80, 312, 412) vers le poste d'impression (18) du système d'impression, et dans lequel l'unité de commande (2) commande la source de flux d'air (56, 356, 456, 466, 556) sur la base de l'opération d'alimentation par le système de commande d'alimentation (46).

13. Kit de flux d'air pour le conditionnement d'une enceinte de stockage de support d'enregistrement (12, 80, 312, 412), l'enceinte de stockage de support d'enregistrement (12, 80, 312, 412) comprenant une ouverture de sortie (60, 94) pour libérer une partie d'un support d'enregistrement (34, 83) vers le poste d'impression (18) du système d'impression, dans lequel le kit de flux d'air comprend :
a) une source de flux d'air (56, 356, 456, 466, 556) pour la fourniture d'un flux d'air de circulation dans l'enceinte de stockage de support d'enregistrement (12, 80, 312, 412) entre une première extrémité (12a, 80a, 312a, 412a) de l'enceinte de stockage de support d'enregistrement (12, 80, 312, 412) adjacente à l'ouverture de sortie (60, 94) et une seconde extrémité (12b, 80b, 312b, 412b) de l'enceinte de stockage de support d'enregistrement (12, 80, 312, 412) en regard de la première extrémité (12a, 80a, 312a, 412a) ; et
b) un collecteur de flux d'air (54, 354, 364, 454, 464, 554) pour la direction du flux d'air à la première extrémité (12a, 80a, 312a, 412a) de l'enceinte de stockage de support d'enregistrement (12, 80, 312, 412) dans une direction de flux d'air principale (M, M₁, M₂, M₃, M₄) adjacente à l'ouverture de sortie (60, 94) ; et **caractérisé en ce qu'**il comprend en outre :
c) un moyen de distribution (59, 40) pour la direction d'une première partie de circulation du flux d'air (F₁, D₁, E₁, G₁) de la première extrémité (12a, 80a, 312a, 412a) à la seconde extrémité (12b, 80b, 312b, 412b) de l'enceinte de stockage de support d'enregistrement (12, 80, 312, 412) et la direction d'une seconde partie du flux d'air (F₂, D₂, E₂, G₂) vers l'ouverture de sortie (60, 94) afin de fournir une surpression dans l'enceinte de stockage de support d'enregistrement (12, 80, 312, 412) adjacente à l'ouverture de sortie (60, 94) par rapport à une pression ambiante à l'extérieur de l'enceinte de stockage de support d'enregistrement (12, 80, 312, 412) ;
d) un conduit (58, 358, 368, 458, 468, 558) agencé pour acheminer le flux d'air de la seconde extrémité (12b, 80b, 312b, 412b) de l'enceinte de stockage de support d'enregistrement (12, 80, 312, 412) vers le collecteur de flux d'air (54, 354, 364, 454, 464, 554).

14. Procédé de fourniture d'un kit de flux d'air selon la revendication 13 dans une enceinte de stockage de support d'enregistrement (12, 80, 312, 412) pour le conditionnement de l'enceinte de stockage de support d'enregistrement (12, 80, 312, 412) comportant :
a) l'agencement de la source de flux d'air (56, 356, 456, 466, 556) entre la première extrémité (12a, 80a, 312a, 412a) et la seconde extrémité (12b, 80b, 312b, 412b) de l'enceinte de stockage de support d'enregistrement (12, 80, 312, 412) et reliant la source de flux d'air (56, 556) à une unité de commande (2) ;
b) l'agencement du collecteur de flux d'air (54, 354, 364, 454, 464, 554) à la première extrémité (12a, 80a, 312a, 412a) de l'enceinte de stockage de support d'enregistrement (12, 80, 312, 412) de sorte qu'en fonctionnement de la source de flux d'air (56, 356, 456, 466, 556), un flux d'air soit dirigé dans une direction de flux d'air principale (M, M₁, M₂, M₃, M₄) adjacente à l'ouverture de sortie (60, 94) ;
c) l'agencement du moyen de distribution (59, 40) dans une position le long de la direction de flux d'air principale (M) adjacente à l'ouverture de sortie (60, 94 ) ;
d) l'agencement du conduit (58, 358, 368, 458, 468, 558) entre la seconde extrémité (12b, 80b, 312b, 412b) de l'enceinte de stockage de support d'enregistrement (12, 80, 312, 412) et le collecteur de flux d'air (54, 354, 364, 454, 464, 554) à la première extrémité (12a, 80a, 312a, 412a) de l'enceinte de stockage de support d'enregistrement (12, 80, 312, 412) ; et
e) le couplage de la source de flux d'air (56, 356, 456, 466, 556) au conduit (58, 358, 368, 458, 468, 558) et au collecteur de flux d'air (54, 354, 364, 454, 464, 554) de sorte qu'en fonctionnement de la source de flux d'air (56, 356, 456, 466, 556), le flux d'air soit déplacé de la seconde extrémité (12b, 80b, 312b, 412b) au collecteur de flux d'air (54, 354, 364, 454, 464, 554) à la première extrémité (12a, 80a, 312a, 412a) de l'enceinte de stockage de support d'enregistrement (12, 80, 312, 412).
